(19) Europäisches Patentamt
European Patent Office
Office européen des brevets

(11) **EP 0 961 528 B1**

(12) **EUROPÄISCHE PATENTSCHRIFT**

(45) Veröffentlichungstag und Bekanntmachung des Hinweises auf die Patenterteilung:
**16.06.2010   Patentblatt 2010/24**

(51) Int Cl.:
**H05H 1/46** *(2006.01)*      **H01J 37/32** *(2006.01)*

(21) Anmeldenummer: **99105215.0**

(22) Anmeldetag: **13.03.1999**

(54) **Vorrichtung zur Erzeugung von Plasma**

Device for plasma generation

Dispositif pour la génération de plasma

(84) Benannte Vertragsstaaten:
**BE DE FR GB NL**

(30) Priorität: **29.05.1998   DE 19824077**

(43) Veröffentlichungstag der Anmeldung:
**01.12.1999   Patentblatt 1999/48**

(73) Patentinhaber: **Oerlikon Deutschland Holding GmbH**
**50968 Köln (DE)**

(72) Erfinder: **Liehr, Michael, Dr.**
**36325 Feldatal (DE)**

(56) Entgegenhaltungen:
**EP-A- 0 459 177      DE-A- 4 337 119**
**DE-C- 19 503 205     JP-A- 02 037 698**
**US-A- 4 265 730      US-A- 4 566 403**

## Beschreibung

Die Erfindung betrifft eine Vorrichtung zur Erzeugung von Plasma in einer Vakuumkammer mit Hilfe von elektromagnetischen Wechselfeldern, wobei zumindest ein stabförmiger Leiter innerhalb eines Rohres aus isolierendem Werkstoff in die Vakuumkammer hineinragt und der Innendurchmesser des Isolierrohres größer als der Durchmesser des Leiters ist, wobei das Isolierrohr zumindest an einem Ende in einer Wand der Vakuumkammer gehalten und gegenüber dieser an seiner Außenfläche abgedichtet ist und der Leiter zumindest an einem Ende an eine Quelle zur Erzeugung der elektromagnetischen Wechselfelder angeschlossen ist.

Eine bekannte Vorrichtung zur Erzeugung von Plasma (DE 195 03 205) ermöglicht es, in einem begrenzten Betriebsbereich (Prozeßbereich, Gasdruck, Mikrowellenleistung) Plasmen für Oberflächenbehandlungen und Beschichtungstechnik zu erzeugen. Die bekannte Vorrichtung besteht im wesentlichen aus einem in einer Vakuumprozeßkammer installierten zylindrischen Glasrohr und einem darin befindlichen metallisch leitenden Rohr, wobei im Innenraum des Glasrohrs Atmosphärendruck herrscht. Mikrowellenleistung wird beidseitig durch zwei Einspeisungen und zwei metallische Koaxialleitungen, bestehend aus Innenleiter und Außenleiter, durch die Wände der Vakuumprozeßkammer eingeleitet. Der fehlende Außenleiter der Koaxialleitung innerhalb der Vakuumprozeßkammer wird durch eine Plasmaentladung ersetzt, die bei hinreichenden Zündbedingungen (Gasdruck) durch die Mikrowellenleistung gezündet und aufrechterhalten wird, wobei die Mikrowellenleistung aus den beiden metallischen Koaxialleitungen und durch das Glasrohr in die Vakuumprozeßkammer austreten kann. Das Plasma umschließt das zylinderförmige Glasrohr von außen und bildet zusammen mit dem Innenleiter eine Koaxialleitung mit sehr hohem Dämpfungsbelag. Bei feststehender, beidseitig eingespeister Mikrowellenleistung kann der Gasdruck der Vakuumprozeßkammer so eingestellt werden, daß das Plasma augenscheinlich gleichmäßig entlang der Vorrichtung dort brennt, wo innerhalb der Vakuumprozeßkammer der Außenleiter der Koaxialleitung fehlt.

DE 43 37 119 offenbart eine Vorrichtung zur Erzeugung von Plasma in einer Vakuumkammer mit Hilfe von elektromagnetischen Wechselfeldern, wobei ein stabförmiger Leiter innerhalb eines isolierendes Rohres durch die Vakuumkammer führbar ist und der Innendurchmesser des Isolierrohres grösser als der Durchmesser des Leiters ist, wobei der stabförmige Leiter im Bereich seiner sich in die Vakuumkammer hinein erstreckenden Partie als Wendel ausgeformt ist.

Bekannt ist weiterhin eine Vorrichtung zur lokalen Erzeugung eines Plasmas in einer Behandlungskammer mittels Mikrowellenanregung (DE 41 36 297), die durch einen in eine Wand einbaubaren Flansch oder die Wand selbst in einen äußeren und einen inneren Teil unterteilt ist, wobei am äußeren Teil eine Mikrowellen-Erzeugungseinrichtung angeordnet ist, deren Mikrowellen über eine Mikrowellen-Einkoppeleinrichtung zum inneren Teil hingeführt werden, wobei die Mikrowellen-Einkoppeleinrichtung einen durch den Flansch hindurchführenden äußeren Führungshohlleiter aus isolierendem Material aufweist, in dem ein Innenleiter aus Metall verläuft, wobei die Mikrowellen von der Mikrowellen-Erzeugungseinrichtung in den Innenleiter eingekoppelt werden.

Schließlich hat man eine Vorrichtung zur Erzeugung von Plasma in einer Vakuumkammer mit Hilfe von elektromagnetischen Wechselfeldern vorgeschlagen (DE 197 22 272.2), bei der ein stabförmiger Leiter innerhalb eines Rohres aus isolierendem Werkstoff durch die Vakuumkammer geführt ist und der Innendurchmesser des Isolierrohres größer als der Durchmesser des Leiters ist, wobei das Isolierrohr an beiden Enden in Wänden der Vakuumkammer gehalten und gegenüber den Wänden an seiner Außenfläche abgedichtet ist und der Leiter an beiden Enden jeweils an eine erste Quelle zur Erzeugung der elektromagnetischen Wechselfelder angeschlossen ist, wobei der stabförmige Leiter jeweils im Bereich beider Wanddurchführungen in Richtung auf seine mittlere Partie zu ein Stück weit von einem Rohrstück aus elektrisch leitendem Werkstoff beabstandet umschlossen ist, wobei die beiden Rohrstücke konzentrisch zum Isolierrohr angeordnet und jeweils die kreisringzylinderförmigen, vom Isolierrohr und dem jeweiligen Rohrstück gebildete Zwischenräume an eine zweite Quelle zur Erzeugung eines elektromagnetischen Wechselfeldes angeschlossen sind.

Der vorliegenden Erfindung liegt die Aufgabe zugrunde, eine Vorrichtung der infrage stehenden Art zu schaffen, die geeignet ist, Schwankungen in der abgeschiedenen Schicht, die auf dem Auftreten von Schwellenfeldern in den Mikrowellen beruhen, zu vermeiden. Die Vorrichtung soll außerdem preiswert herstellbar sein, insbesondere soll der Einbau kostspieliger Einwegleitungen zum Schutz von Mikrowellensendern von reflektierter Leistung vermieden werden; d. h. die Antenne soll so ausgebildet sein, daß sie zusätzlich zu der jeder Antenne eigenen Abstrahlungscharakteristik noch die Eigenschaft besitzt, hochfrequente Wellen abstrahlen zu können, ohne die von der Applikation (z. B. dem Plasma) reflektierte Leistung wieder aufzunehmen.

Diese Aufgabe wird erfindungsgemäß dadurch gelöst, daß der stabförmige Leiter im Bereich seiner sich in die Vakuumkammer hinein erstreckenden Partie als Wendel ausgeformt ist, wobei die Windungslänge dieser Partie etwa einer Wellenlänge $\lambda$ bei einem Steigungswinkel von $10° < \alpha < 15°$ entspricht.

Bei einer bevorzugten Ausführungsform sind die stabförmigen Leiter innerhalb eines Rohres aus isolierendem Werkstoff durch die Vakuumkammer geführt, wobei der Innendurchmesser des Isolierrohres größer als der Durchmesser der Leiter ist und das Isolierrohr an beiden Enden in Wänden der Vakuumkammer gehalten und gegenüber den Wänden an seiner Außenfläche abgedichtet ist und die Leiter jeweils an eine eigene Quelle zur Erzeugung von elektromagnetischen Wechselfeldern angeschlossen sind, wobei die stabförmigen Leiter im Bereich ihrer sich in die Vakuumkammer hinein erstreckenden Partien als Wendel ausgeformt sind und die Windungslängen dieser beiden Partien etwa einer Wellenlänge $\lambda$ und einem Winkel von $10° < \alpha < 15°$ entsprechen.

Bei einer alternativen Ausführungsform sind stabförmige Leiter innerhalb von Rohren aus isolierendem Werkstoff durch die Vakuumkammer geführt, wobei die Innendurchmesser der Isolierrohre jeweils größer als die Durchmesser der Leiter sind und die Isolierrohre mit jeweils einem Ende in Wänden der Vakuumkammer gehalten und jeweils gegenüber den Wänden an ihrer Außenfläche abgedichtet sind, wobei jeder Leiter mit einem Ende jeweils an eine Quelle zur Erzeugung von elektromagnetischen Wechselfeldern angeschlossen ist, wobei die stabförmigen Leiter im Bereich ihrer sich in die Vakuumkammer hinein erstreckenden Partien als Wendel ausgeformt sind und die Windungslängen dieser beiden Partien etwa einer Wellenlänge $\lambda$ und einem Steigungswinkel von $10° < \alpha < 15°$ entsprechen.

Die Erfindung läßt die verschiedensten Ausführungsmöglichkeiten zu; drei davon sind in den anhängenden Zeichnungen rein schematisch dargestellt, und zwar zeigen:

Fig. 1      den Schnitt durch eine Vorrichtung mit einer Wendel und einem vakuumkammerseitig geschlossenen Isolierrohr,

Fig. 2      die einzelne Darstellung einer typischen Wendel,

Fig. 2a      die Abwicklung einer Wendel,

Fig. 3      die Darstellung der Plasmawolke bei einem Betrieb der Vorrichtung nach Fig. 1 im $T_1$ mode,

Fig. 3a      die Darstellung der Plasmawolke bei einem Betrieb der Vorrichtung nach Fig. 1 im $T_0$ mode,

Fig. 4      die Darstellung der Plasmawolke bei einer Ausführungsform mit zwei einander gegenüberliegend angeordneten Wendeln in jeweils geschlossenen Isolierrohren und

Fig. 5      die Darstellung der Plasmawolke bei einer Vorrichtung ähnlich derjenigen nach Fig. 4, jedoch mit einem gemeinsamen, beide Wendel umgreifenden Isolierrohr.

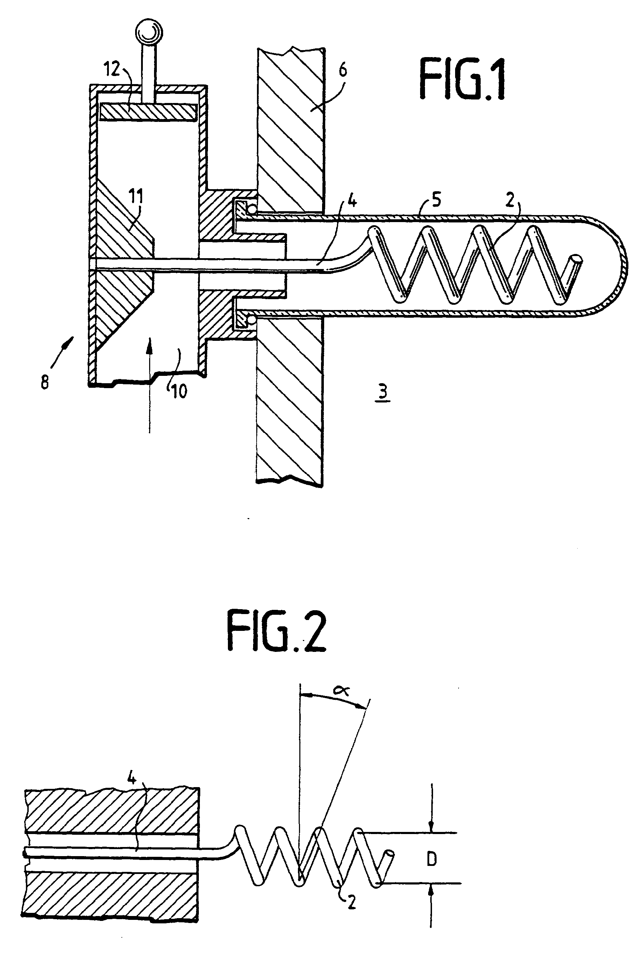

Die in Fig. 1 dargestellte Vorrichtung betrifft eine Wendel-Antenne, die im $T_1$ mode betrieben wird, wobei zirkular polarisierte Mikrowellenstrahlung entlang der Mittelachse vom freien Ende der Wendel aus abgestrahlt wird und eine Plasmaentladung zündet und aufrechterhält.

Mikrowellenleistung wird mittels einer Rechteckhohlleitung 10 von einem Mikrowellengenerator zugeführt, die mittels Impedanzanpassungselementen 11,12 auf eine Koaxialleitung 4 übertragen wird. Die Wendel der Antenne 2 ist mit dem Innenleiter der Koaxialleitung 4 verbunden und wandelt die transversal elektromagnetischen Wellen der Koaxialleitung in zirkular polarisierte Wellen um und strahlt diese durch ein vakuumdichtes, aber mikrowellendurchlässiges Rohr 5 in die Vakuumkammer 3 ab. Die metallisch leitende Wand 6 der Vakuumkammer 3 dient dabei als Reflektorschild für Rückwärtswellen.

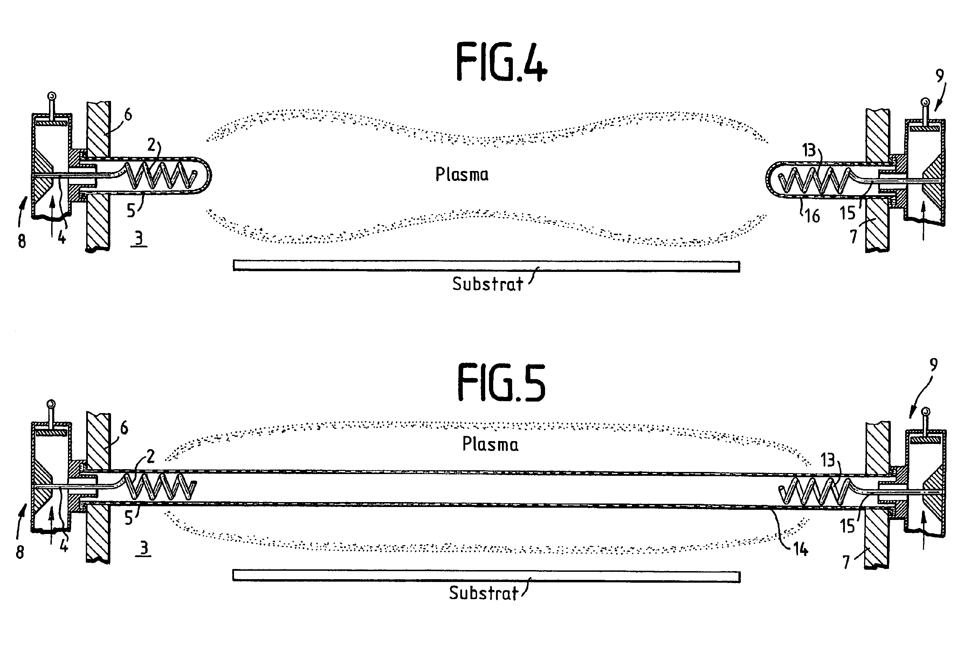

Mehrere Vorrichtungen des beschriebenen Typs können Mikrowellenleistung in ein und dieselbe Plasmabehandlungskammer abstrahlen (Fig. 4), wobei die einzelnen Antennen mikrowellentechnisch entkoppelt sind, vorausgesetzt, gegenüberliegend angeordnete Vorrichtungen haben entgegengesetzte Wickelrichtungen (Helizität).

Genauer gesagt: besitzt die Vorrichtung auf der einen Seite rechtsdrehende Helizität, muß die andere Vorrichtung von linksdrehender Helizität sein. Unter idealen Bedingungen kann linkszirkular polarisierte Mikrowellenstrahlung von einer rechtsdrehenden Helix-Antenne (Wendel-Antenne) nicht absorbiert werden und umgekehrt. Zirkular polarisierte Mikrowellenstrahlung ändert bei Reflexion an metallisch leitenden planaren Oberflächen ihre jeweilige Polarisationsrichtung.

Je zwei gegenüberliegende erfindungsgemäße Vorrichtungen können in einem gemeinsamen, vakuumdichten und mikrowellendurchlässigen Rohr angeordnet werden, wie Fig. 5 zeigt, wobei die beiden Vorrichtungen von entgegengesetzter Helizität sind.

Die aus den erfindungsgemäßen Vorrichtungen in Vorwärtsrichtung abgestrahlte Mikrowellenleistung erzeugen Plasmaentladungen, das für Mikrowellenstrahlung aus wellenmechanischer Sichtweise ein absorbierendes Dielektrikum darstellt, in dem Mikrowellen eine starke Dämpfung erfahren. Um die Dämpfung abzuschwächen und damit die geometrische Form des Plasmas zu verändern (speziell: in Längsrichtung zu strecken) kann es vorteilhaft sein, einen plasmafreien Verbindungskanal zwischen den beiden Vorrichtungen schaffen. Bei entsprechender Wahl der Betriebsparameter kann eine geschlossene Plasmasäule zwischen jeweils zwei gegenüber angeordneten erfindungsgemäßen Vorrichtungen erzeugt werden, die weitgehend frei von Stehwellenfeldmustern ist.

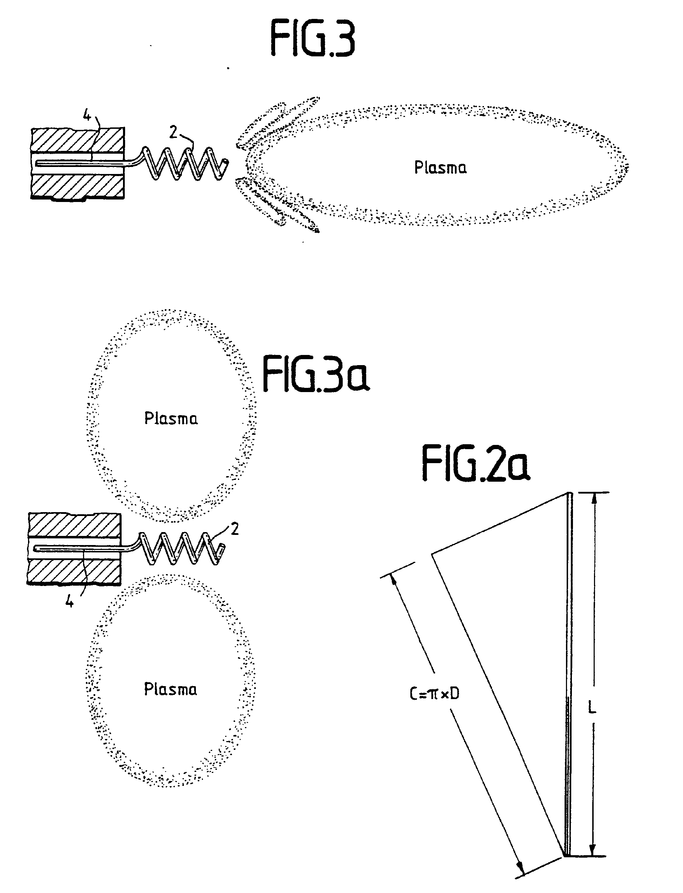

Die zur Abstrahlung von Mikrowellen benutzte helikal geformte Stabantenne (auch als Helix bezeichnet) ist so beschaffen, daß sie im sogenannten $T_1$-mode betrieben wird. Fig. 2 zeigt eine Helix-Antenne mit ca. 4 Windungen, die über eine Koaxialleitung mit Mikrowellenleistung versorgt wird. Die Strahlungscharakteristik einer Helix hängt erstens vom Verhältnis des Windungsdurchmessers D zu der Wellenlänge $\lambda_0$ der applizierten Mikrowellen und zweitens vom Windungssteigungswinkel $\alpha$ ab. Je nach Wahl dieser Parameter strahlt die Helix-Antenne im Extremfall in zwei verschiedenen moden, die weitgehend komplementäre Strahlungscharakteristika zeigen, wie in Fig. 3 angedeutet.

**T$_1$ mode**:

Windungslänge $L=C/cos(\alpha)$ entspricht annähernd einer Wellenlänge $\lambda_0$ und $10°<\alpha<15°$.

In diesem Betriebszustand strahlt die Helix-Antenne mit einem stark ausgeprägtem Hauptmaximum und kleinen Nebenmaxima konzentrisch zur Helix-Mittelachse vom freien Ende der Helix aus (endfire). Darüber besitzt die Strahlung bei Helix-Antennen mit mindestens 4 Windungen weitgehend zirkulare Polarisation, deren Drehsinn von der Helizität der Antenne festgelegt wird. Helix-Antennen dieser Art werden als Kraus-Coil (Monofilar, axial mode $T_1R_1$) bezeichnet. Näheres dazu in Antennas, 2$^{nd}$ Edition, John D. Kraus, McGraw-Hill Book Company, Kapitel 7. Der mögliche Antennengewinn hängt von der Geometrie der Helix, wie Windungsdurchmesser, Windungssteigungswinkel und Gesamtlänge ab und kann bis zu 15 dB betragen, ist dabei aber nahezu unabhängig von dem Durchmesser des rohrförmigen, metallisch leitfähigen Materials und auch dessen spezifischen elektrischen Widerstands (vgl. D. T. Emerson, National Radio Astronomy Observatory, Antenna Compendium Volume 4, pp 64-68, 1995, published by AARL).

**T$_0$ mode**:

Windungslänge $L=C/cos(\alpha)$ ist erheblich kleiner als eine Wellenlänge $\lambda_0$ und $10°<\alpha<15°$.

In diesem Betriebszustand strahlt die Helix mit einer Intensitätsverteilung, deren Maximum annähernd senkrecht zur Helix-Mittelachse verläuft, also radial, ähnlich einer geraden Stabantenne. Dieser Betriebszustand ist die Grundlage für die Vorrichtung gemäß Offenlegungsschrift DE 41 36 297 oder Patentschrift DE 195 03 205. Der $T_0$ mode ist für den erfindungsgemäßen Gegenstand ohne Interesse.

T$_2$, T$_3$, .... mode:

Windungslänge $L=C/cos(\alpha)$ ist erheblich größer als eine Wellenlänge $\lambda_0$ und $10°<\alpha<15°$.

**Bezugszeichenliste**

| 2 | Wendel, Helix |
|---|---|
| 3 | Vakuumkammer |
| 4 | stabförmiger Leiter |
| 5 | Isolierrohr |
| 6 | Kammerwand |
| 8 | Quelle |
| 9 | Quelle |
| 10 | Rechteckhohlleiter |
| 11 | Impedanzanpassungselement |
| 12 | Impedanzanpassungselement |
| 13 | Wendel, Helix |
| 14 | Isolierrohr |
| 15 | stabförmiger Leiter |
| 16 | Isolierrohr |

**Patentansprüche**

1.  Vorrichtung zur Erzeugung von Plasma in einer Vakuumkammer (3) mit Hilfe von elektromagnetischen Wechselfeldern, mit einer ersten Quelle (8 bzw. 9) zur Erzeugung der elektromagnetischen Wechselfeldern wobei ein stabförmiger Leiter (4) innerhalb eines Rohres (5) aus isolierendem Werkstoff durch die Vakuumkammer (3) führbar ist und der Innendurchmesser des Rohres (5) grösser als der Durchmesser des Leiters (4) ist, wobei das Rohr (5) zumindest an einem Ende in einer Wand (6, 7) der Vakuumkammer (3) haltbar ist und der Leiter (4) zumindest an einem Ende der ersten Quelle (8 bzw. 9) angeschlossen ist, wobei die Quelle (8 bzw. 9) eine Wellenlänge $\lambda_0$ appliziert, wobei der stabförmige Leiter (4) im Bereich seiner sich in die Vakuumkammer (3) hinein erstreckenden Partie als Wendel (2) ausgeformt ist, **dadurch gekennzeichnet, dass** das Rohr (5) gegenüber der Aussenfläche der Wand (6, 7) abdichtbar ist, und die Windungslänge L dieser Partie bei einem Windungssteigungswinkel $\alpha$ [$10°<\alpha<15°$] und einem Windungsdurchmesser D den Wert $L=(\pi D)/cos(\alpha)$ hat und etwa der Wellenlänge $\lambda_0$ entspricht.

2.  Vorrichtung zur Erzeugung von Plasma in einer Vakuumkammer (3) mit Hilfe von elektromagnetischen Wechselfeldern, mit Quellen (8, 9) zur Erzeugung der elektromagnetischen Wechselfeldern wobei stabförmige Leiter (4, 15) innerhalb eines Rohres (14) aus isolierendem Werkstoff durch die Vakuumkammer (3) führbar sind und der Innendurchmesser des Rohres (14) grösser als der Durchmesser der Leiter (4, 15) ist, wobei das Rohr (14) an beiden Enden in Wänden (6, 7) der Vakuumkammer (3) haltbar und gegenüber den wänden (6, 7) an seiner Aussenfläche abdichtbar ist und die Leiter (4, 15) jeweils an eine eigene Quelle (8, 9) zur Erzeugung von elektromagnetischen Wechselfeldern angeschlossen sind, wobei die Quellen (8, 9) eine Wellenlänge $\lambda_0$ applizieren, wobei die stabförmigen Leiter (4, 15) im Bereich ihrer sich in die Vakuumkammer (3) hinein erstreckenden Partien als Wendel (2 bzw. 13) ausgeformt sind, wobei die Windungslängen L dieser beiden Partien bei einem Windungssteigungswinkel $\alpha$ [10°<$\alpha$<15°] und einem Windungsdurchmesser D den Wert L=($\pi$D)/cos($\alpha$) haben und etwa der Wellenlänge $\lambda_0$ entsprechen.

3. Vorrichtung nach Anspruch 1 zur Erzeugung von Plasma in einer Vakuumkammer (3) mit Hilfe von elektromagnetischen Wechselfeldern, mit Quellen (8, 9) zur Erzeugung der elektromagnetischen Wechselfeldern, wobei ein zweiter stabförmiger Leiter (15) innerhalb eines zweiten Rohres (16) aus isolierendem Werkstoff durch die Vakuumkammer (3) führbar ist und der Innendurchmesser des Rohres (16) grösser als der Durchmesser des Leiters (15) ist, wobei dieser Rohr (16) mit einem Ende in einer zweiten Wand (7) der Vakuumkammer (3) haltbar und gegenüber dieser an seiner Aussenfläche abdichtbar ist und jeder Leiter (4, 15) mit einem Ende jeweils an eine eigene Quelle (8, 9) zur Erzeugung von elektromagnetischen Wechselfeldern angeschlossen ist, wobei die Quellen (8, 9) eine Wellenlänge $\lambda_0$ applizieren, weiterhin **gekennzeichnet**, dass der zweite stabförmiger Leiter (15) im Bereich seiner sich in die Vakuumkammer (3) hinein erstreckenden Partie als Wendel (13) ausgeformt ist, wobei die Windungslänge L dieser Partie bei einem Windungssteigungswinkel $\alpha$ (10°<$\alpha$<15°] und einem Windungsdurchmesser D den Wert L=($\pi$D)/cos($\alpha$) habt und etwa der Wellenlänge $\lambda_0$ entspricht.

**Claims**

1. Apparatus for generating plasma in a vacuum chamber (3) with the help of electromagnetic alternating fields, with a first source (8 and/or 9) to generate the electromagnetic alternating fields, wherein a rod-shaped conductor (4) can be guided through the vacuum chamber (3) inside a tube (5) of insulating material and the internal diameter of the tube (5) is greater than the diameter of the conductor (4), wherein the tube (5) at least at one end can be held in a wall (6, 7) of the vacuum chamber (3) and the conductor (4) is connected at least at one end of the first source (8 and/or 9), wherein the source (8 and/or 9) applies a wavelength $\lambda_0$, wherein the rod-shaped conductor (4) in the area of its part protruding into the vacuum chamber is formed as a helix (2), **characterised in that** the tube (5) can be sealed against the outer surface of the wall (6, 7), and the winding length L of this part, for a winding pitch angle $\alpha$ [10° < $\alpha$ < 15°] and a winding diameter D, has the value L = ($\pi$D)/cos($\alpha$) and corresponds approximately to the wavelength $\lambda_0$.

2. Apparatus for generating plasma in a vacuum chamber (3) with the help of electromagnetic alternating fields, with sources (8, 9) to generate the electromagnetic alternating fields, wherein rod-shaped conductors (4, 15) can be guided through the vacuum chamber (3) inside a tube (14) of insulating material and the internal diameter of the tube (14) is greater than the diameter of the conductor (4, 15), wherein the tube (14) at both ends can be held in walls (6, 7) of the vacuum chamber (3) and can be sealed against the walls (6, 7) at its outer surface, and the conductors (4, 15) are each connected to a source (8, 9) to generate electromagnetic alternating fields, wherein the sources (8, 9) apply a wavelength $\lambda_0$, wherein the rod-shaped conductors (4, 15) in the area of their part protruding into the vacuum chamber (3) are formed as helices (2 and 13), wherein the winding lengths L of these parts, for a winding pitch angle $\alpha$ [10° < $\alpha$ < 15°] and a winding diameter D, have the value L = ($\pi$D)/cos($\alpha$) and correspond approximately to the wavelength $\lambda_0$.

3. Apparatus according to claim 1 for generating plasma in a vacuum chamber (3) with the help of electromagnetic alternating fields, with sources (8, 9) to generate the electromagnetic alternating fields, wherein a second rod-shaped conductor (15) can be guided through the vacuum chamber (3) inside a second tube (16) of insulating material and the internal diameter of the tube (16) is greater than the diameter of the conductor (15), wherein this tube (16) at one end can be held in a second wall (7) of the vacuum chamber (3) and can be sealed against this at its outer surface, and each conductor (4, 15) is connected at one end to a source (8, 9) to generate electromagnetic alternating fields, wherein the sources (8, 9) apply a wavelength $\lambda_0$, furthermore **characterised in that** the second rod-shaped conductor (15) in the area of its part protruding into the vacuum chamber (3) is formed as a helix (13), wherein the winding length L of this part, for a winding pitch angle $\alpha$ [10° < $\alpha$ < 15°] and a winding diameter D, has the value L = ($\pi$D)/cos($\alpha$) and corresponds approximately to the wavelength $\lambda_0$.

**Revendications**

1. Dispositif de génération de plasmas dans une chambre à vide (3) à l'aide de champs électromagnétiques alternatifs, ledit dispositif comportant une première source (8 resp. 9) destinée à générer les champs électromagnétiques alternatifs, un conducteur en forme de barre (4) à l'intérieur d'un tube (5) en matière isolante pouvant être guidé à travers la chambre à vide (3) et le diamètre intérieur du tube (5) étant supérieur au diamètre du conducteur (4), le tube (5) pouvant être maintenu au moins à une extrémité dans une paroi (6, 7) de la chambre à vide (3) et le conducteur (4) étant raccordé au moins à une extrémité de la première source (8 resp. 9), la source (8 resp. 9) appliquant une longueur d'onde $\lambda_0$, le conducteur en forme de barre (4) étant conformé en hélice (2) dans la région de sa partie qui s'étend vers l'intérieur de la chambre à vide (3), **caractérisé en ce que**, pour un angle d'inclinaison d'enroulement $\alpha$ [10° < $\alpha$ < 15°] et un diamètre d'enroulement D, la longueur d'enroulement L de cette partie a la valeur L = ($\pi$D)/cos($\alpha$) et correspond à peu près à la longueur d'onde $\lambda_0$.

2. Dispositif de génération de plasmas dans une chambre à vide (3) à l'aide de champs électromagnétiques alternatifs, ledit dispositif comportant des sources (8, 9) destinées à générer les champs électromagnétiques alternatifs, des conducteurs en forme de barre (4, 15) à l'intérieur d'un tube (14) en matière isolante pouvant être guidés à travers la chambre à vide (3) et le diamètre intérieur du tube (14) étant supérieur au diamètre des conducteurs (4, 15), le tube (14) pouvant être maintenu aux deux extrémités dans des parois (6, 7) de la chambre à vide (3) et pouvant être rendu étanche vis-à-vis des parois (6, 7) au niveau de sa surface extérieure et les conducteurs (4, 15) étant chacun raccordés à une source propre (8, 9) destinée à générer des champs électromagnétiques alternatifs, les sources (8, 9) appliquant une longueur d'onde $\lambda_0$, les conducteurs en forme de barre (4, 15) étant conformés en hélice (2 resp. 13) dans la région de leur partie qui s'étend vers l'intérieur de la chambre à vide (3) et, pour un angle d'inclinaison d'enroulement $\alpha$ [10° < $\alpha$ < 15°] et un diamètre d'enroulement D, la longueur d'enroulement L de ces deux parties ayant la valeur L = ($\pi$D)/cos($\alpha$) et correspondant à peu près à la longueur d'onde $\lambda_0$.

3. Dispositif selon la revendication 1 destiné à générer des plasmas dans une chambre à vide (3) à l'aide de champs électromagnétiques alternatifs, ledit dispositif comportant des sources (8, 9) destinées à générer les champs électromagnétiques alternatifs, un deuxième conducteur en forme de barre (15) à l'intérieur d'un deuxième tube (16) en matière isolante pouvant être guidé à travers la chambre à vide (3) et le diamètre intérieur du tube (16) étant supérieur au diamètre du conducteur (15), ce tube (16) pouvant être maintenu par une extrémité dans une seconde paroi (7) de la chambre à vide (3) et pouvant être rendu étanche par rapport à celle-ci au niveau de sa surface extérieure et chaque conducteur (4, 15) étant raccordé par une extrémité à une source propre (8, 9) destinée à générer des champs électromagnétiques alternatifs, les sources (8, 9) appliquant une longueur d'onde $\lambda_0$, **caractérisé en outre en ce que** le deuxième conducteur en forme de barre (15) est conformé en hélice (13) dans la région de sa partie qui s'étend vers l'intérieur de la chambre à vide (3) et, pour un angle d'inclinaison d'enroulement $\alpha$ [10° < $\alpha$ < 15°] et un diamètre d'enroulement D, la longueur d'enroulement L de cette partie ayant la valeur L = ($\pi$D)/cos($\alpha$) et correspondant à peu près à la longueur d'onde $\lambda_0$.

EP 0 961 528 B1

FIG.1

FIG.2

7

# FIG.3

# FIG.3a

# FIG.2a

Plasma

Plasma

Plasma

$C = \pi \times D$

L

FIG.4

FIG.5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19503205
- DE 4337119
- DE 4136297
- DE 19722272

**In der Beschreibung aufgeführte Nicht-Patentliteratur**

- National Radio Astronomy Observatory. **D. T. Emerson.** Antenna Compendium. AARL, 1995, vol. 4, 64-68